**Europäisches Patentamt**

**European Patent Office**

**Office européen des brevets**

(19)

(11)    **EP 1 006 366 A1**

(12)    **DEMANDE DE BREVET EUROPEEN**

(43) Date de publication:
    **07.06.2000   Bulletin 2000/23**

(51) Int Cl.$^7$: **G01R 33/44**

(21) Numéro de dépôt: **99402964.3**

(22) Date de dépôt: **29.11.1999**

(84) Etats contractants désignés:
    **AT BE CH CY DE DK ES FI FR GB GR IE IT LI LU
    MC NL PT SE**
    Etats d'extension désignés:
    **AL LT LV MK RO SI**

(30) Priorité:   **01.12.1998   FR 9815139**

(71) Demandeur: **Commissariat à l'Energie Atomique
    75752 Paris Cedex 15 (FR)**

(72) Inventeurs:
    • **Locatelli, Marcel
      38330 Montbonnot (FR)**
    • **Chaillout, Jean-Jacques
      38960 Saint-Etienne de Crossey (FR)**

(74) Mandataire: **Des Termes, Monique et al
    Société Brevatome
    3, rue du Docteur Lancereaux
    75008 Paris (FR)**

(54)    **Mesure rmn sur des objects de volume important**

(57)    L'invention concerne la caractérisation par
RMN d'un object perméable poreux. Cette caractérisation est obtenue en:

- déplaçant l'objet (1) à une vitesse connue et dans
  une direction donnée pour que des anneaux concentriques de chacune des tranches successives
  de cet objet subissent une mesure RMN grâce à un
  champ magnétique statique ($B_o$) et à un champ
  électromagnétique RF de direction perpendiculaire
  au champ magnétique statique et de fréquence
  égale à la fréquence de résonance définie par le
  champ magnétique statique,
- soumettant les anneaux concentriques de chacune
  des tranches à l'effet combiné du champ magnétique statique dont l'intensité est ajustée et du champ
  électromagnétique RF fourni sous forme d'impulsions dont l'amplitude et la durée sont ajustées,
- recueillant, pour les anneaux concentriques de chacune des tranches, des données de mesure RMN,
  pondérant les données recueillies en fonction du
  volume des anneaux concentriques soumis à la mesure RMN,
- délivrant les données pondérées à un ordinateur
  (16) qui les compare à des valeurs emmagasinées,
  obtenues par étalonnage ou modélisation sous des
  conditions de mesure identiques, pour fournir des
  données de caractérisation de l'objet (1) consistant
  en son taux d'humidité et/ou sa porosité et/ou la
  taille de ses pores.

FIG. 1

## Description

### Domaine technique

La présente invention concerne la caractérisation d'objets perméables poreux contenant à un moment donné un milieu apte à une mesure par résonance magnétique nucléaire (RMN). Ce milieu peut être un liquide pour lequel la mesure RMN se fait sur les protons de l'hydrogène. Ce milieu peut aussi être un gaz polarisé.
Une application particulière de la présente invention concerne la mesure du taux d'humidité de balles de papier de récupération.

### Etat de la technique antérieure

Le brevet américain n° 5 309 098 (Coates et al.) divulgue un procédé de mesure de la porosité de formations géologiques à partir de la RMN du proton de l'hydrogène contenu dans le pétrole. Cette mesure, à partir d'un liquide, est une technique simple mais locale. Elle met en oeuvre un champ magnétique statique et un champ radiofréquence fixes. Dans ce domaine d'application, on utilise des systèmes RMN du type de surface. Ces systèmes ne permettent pas une mesure sur l'ensemble d'un volume. De plus, les conditions d'environnement sont moins perturbées que sur un site industriel.
Une mesure RMN mettant en oeuvre un gaz polarisé est également connue. Elle permet d'éviter la présence d'un liquide. Ainsi, à partir de la résonance de l'hélium 3, l'imagerie RMN permet de visualiser par exemple la porosité des poumons. Cette technique a notamment été divulguée dans l'article "Low-field $^3$He nuclear magnetic résonance in human lungs" de L. DARRASSE, G. GUILLOT, P.-J. NACHER et G. TASTEVIN, C.R. Acad. Sci. Paris, t. 324, série IIb, p. 691-700, 1997. C'est une technique chère, très complexe et difficilement applicable sur un site industriel. En effet, le champ radiofréquence est fixe et on fait varier le champ magnétique statique en direction et en intensité afin d'explorer toute la zone à étudier.

### Exposé de l'invention

L'invention a été conçue pour remédier à ces inconvénients. Elle permet la mesure du taux d'humidité et/ou de la porosité et/ou de la taille des pores d'un objet dont le volume peut être important, la mesure pouvant être effectuée sur un site industriel, donc perturbé et impliquant une sécurité d'exploitation.
L'invention est basée sur des mesures réalisées en rendant variable les champs magnétiques statique et RF.
Un objet de la présente invention est une méthode de caractérisation par RMN d'un objet perméable poreux, consistant à :

- déplacer ledit objet à une vitesse connue et dans une direction donnée pour que des anneaux concentriques de chacune des tranches successives de cet objet subissent une mesure RMN grâce à un champ magnétique statique et à un champ électromagnétique RF de direction perpendiculaire au champ magnétique statique et de fréquence égale à la fréquence de résonance définie par le champ magnétique statique,
- soumettre les anneaux concentriques de chacune des tranches à l'effet combiné dudit champ magnétique statique dont l'intensité est ajustée et dudit champ électromagnétique RF fourni sous forme d'impulsions dont l'amplitude et la durée sont ajustées,
- recueillir, pour les anneaux concentriques de chacune des tranches, des données de mesure RMN,
- pondérer les données recueillies en fonction du volume des anneaux concentriques soumis à la mesure RMN,
- délivrer les données pondérées à un ordinateur qui les compare à des valeurs emmagasinées, obtenues par étalonnage ou modélisation sous des conditions de mesure identiques, pour fournir des données de caractérisation de l'objet consistant en son taux d'humidité et/ou sa porosité et/ou la taille de ses pores.

Avantageusement, l'intensité du champ magnétique statique est ajustée par variation du courant continu alimentant une bobine d'induction.
De préférence, le champ magnétique statique est de direction parallèle au déplacement dudit objet, le champ électromagnétique RF étant de direction perpendiculaire au déplacement dudit objet.
Un autre objet de la présente invention est constitué par un dispositif de caractérisation par RMN d'un objet perméable poreux pour en déterminer le taux d'humidité et/ou la porosité et/ou la taille des pores, comportant :

- des moyens de déplacement dudit objet à une vitesse déterminée et dans une direction déterminée,
- des moyens de production d'un champ magnétique statique d'intensité ajustable, aptes à générer ce champ magnétique statique de façon homogène dans des anneaux concentriques de chacune des tranches successives dudit objet,
- des moyens de production d'un champ électromagnétique RF, aptes à générer ce champ électromagnétique RF de façon homogène dans les anneaux concentriques de chacune des tranches dudit objet, dans une direction perpendiculaire au champ magnétique statique, à une fréquence égale à la fréquence de résonance définie par le champ magnétique statique et sous forme d'impulsions dont l'amplitude et la durée sont ajustables,
- des moyens de mesure RMN recueillant, pour lesdits anneaux concentriques de chacune des tranches, les données de mesure RMN,

- un ordinateur auquel sont fournies les données de mesure RMN et qui les compare à des valeurs emmagasinées obtenues par étalonnage ou modélisation sous des conditions de mesure identiques pour délivrer des données de caractérisation de l'objet.

Les moyens de déplacement de l'objet peuvent être constitués par un tapis roulant.

Avantageusement, les moyens de déplacement dudit objet, les moyens de production d'un champ magnétique statique et les moyens de production d'un champ électromagnétique RF sont disposés de façon que le champ magnétique statique soit parallèle au déplacement de l'objet et de façon que le champ électromagnétique RF soit perpendiculaire au déplacement de l'objet.

Les moyens de production d'un champ magnétique statique peuvent comprendre des moyens à bobine d'induction pour ajuster l'intensité du champ magnétique statique grâce à une variation de courant continu. Ils peuvent en outre comprendre des moyens à aimant permanent.

Les moyens de production d'un champ électromagnétique RF peuvent être des moyens à bobine d'induction alimentée par une source RF. Cette bobine peut comporter un noyau en matériau magnétique, par exemple en ferrite doux. Elle peut aussi être pourvue d'un écran électromagnétique de protection réalisé en un matériau présentant une conductivité électrique et une perméabilité magnétique non nulles. Cet écran électromagnétique peut être en fer doux.

Un circuit magnétique peut être associé aux moyens à bobine d'induction pour la production d'un champ électromagnétique RF, le circuit magnétique permettant de favoriser la circulation du flux électromagnétique RF. Avantageusement, ce circuit magnétique est un circuit de type "Watson". Il peut être pourvu d'un écran électromagnétique de protection réalisé en un matériau présentant une conductivité électrique et une perméabilité magnétique non nulles.

Les moyens de mesure RMN peuvent être des moyens aptes à mettre en oeuvre des séquences CPMG.

Le dispositif selon l'invention s'applique en particulier à la caractérisation de balles de papier cerclées par des liens métalliques parallèles définissant des plans de cerclage, la mesure RMN s'effectuant avec un champ électromagnétique RF tel que la somme des flux entrant et sortant d'un plan de cerclage soit nulle et avec un champ magnétique statique de direction perpendiculaire à celle du champ RF. De façon particulière, le champ RF est dans le plan de cerclage. D'autre part, les parties mesurées dans chacune des tranches peuvent être avantageusement des anneaux.

## Brève description des dessins

L'invention sera mieux comprise et d'autres avantages et particularités apparaîtront à la lecture de la description qui va suivre, donnée à titre d'exemple non limitatif, accompagnée des figures annexées parmi lesquelles :

- la figure 1 représente un dispositif de caractérisation par RMN d'un objet perméable poreux, selon la présente invention,
- la figure 2 est une vue sous un autre angle du dispositif de la figure 1,
- la figure 3 représente une première variante d'une bobine d'induction destinée à fournir un champ électromagnétique RF pour le dispositif de la présente invention,
- la figure 4 représente une deuxième variante d'une bobine d'induction destinée à fournir un champ électromagnétique RF pour le dispositif de la présente invention,
- la figure 5 représente une troisième variante d'une bobine d'induction destinée à fournir un champ électromagnétique RF pour le dispositif de la présente invention,
- la figure 6 est un diagramme représentant un signal d'une séquence CPMG mise en oeuvre dans la présente invention,
- les figures 7 et 8 sont des vues, respectivement de face et de côté, illustrant une autre façon de fournir un champ électromagnétique RF pour le dispositif de la présente invention,
- les figures 9 et 10 sont des vues, respectivement de face et de côté, illustrant une variante de réalisation du dispositif représenté par les figures 7 et 8,
- les figures 11A et 11B sont respectivement des vues de face et de profil et représentent une répartition possible, sur une tranche, des parties subissant une mesure RMN,
- la figure 12 représente la coupe des volumes obtenus, après déplacement de l'objet, à partir des parties testées décrites par les figures 11A et 11B.

## Description détaillée de modes de réalisation de l'invention

L'invention va maintenant être décrite en prenant comme exemple d'objet à caractériser une balle de papier 1 maintenue par des liens métalliques 2 disposés parallèlement entre eux de façon à former des plans de cerclage. La balle de papier 1 est disposée sur un tapis roulant 4 qui permet son déplacement selon une direction donnée et à une vitesse déterminée dans une zone soumise à des champs magnétiques permettant une mesure RMN.

L'induction statique est produite par un système de bobines 6 alimentées par des sources de courant continu 8. Des aimants permanents peuvent aussi être associés à ces bobines d'induction.

L'induction RF est produite par un système de bobines d'induction 10 alimentées par des sources de courant RF 12.

Les différentes sources de courant sont programmables dans le temps.

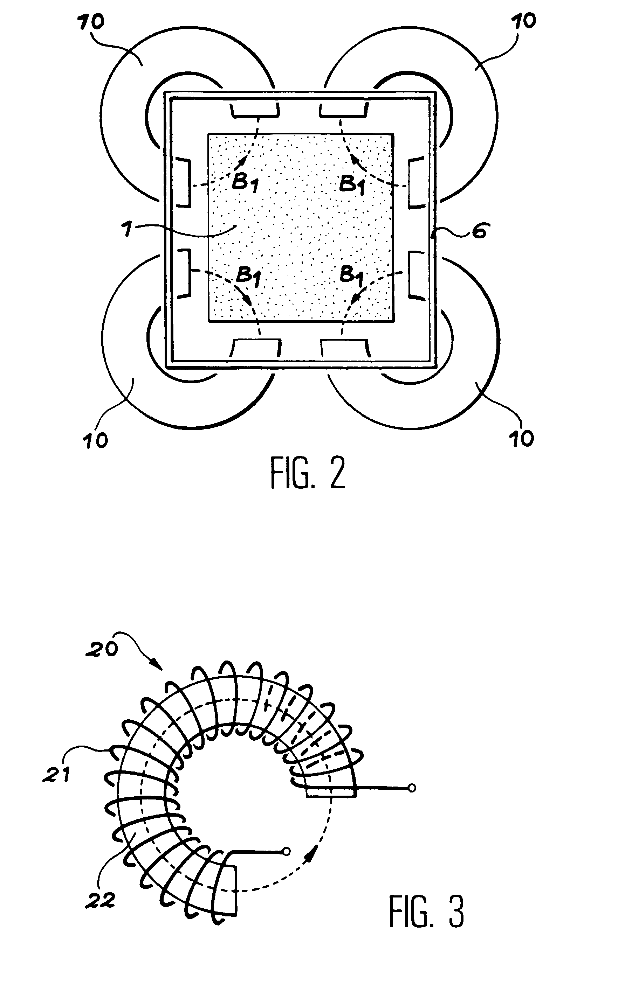

L'induction statique, d'amplitude $B_o$, est, dans l'exemple décrit, parallèle au déplacement de l'objet 1. L'induction statique peut être transverse ou longitudinale à l'objet à caractériser. Il est plus favorable qu'elle soit dirigée selon la section la plus faible. La direction de l'induction RF se situe dans le plan perpendiculaire au déplacement comme cela est mieux visible sur la figure 2 qui représente l'objet 1, vu de côté, soumis à l'induction $B_1$ générée par quatre bobines 10 placées près de ses angles.

La balle de papier 1 est placée de façon que les plans de cerclage soient dans le même plan que la direction de l'induction RF. Ceci permet de limiter le couplage électromagnétique entre les cercles métalliques 2 et les bobines d'induction 10.

La mesure RMN est effectuée dans une partie (par exemple un anneau) d'une section (ou tranche) du volume de l'objet. Pour cela, les conditions de mesure sont obtenues dans la section en faisant varier dans le temps les courants des sources statique et RF ainsi que la durée des impulsions RF. Le déplacement de l'objet 1 est programmé afin de balayer l'ensemble du volume de l'objet.

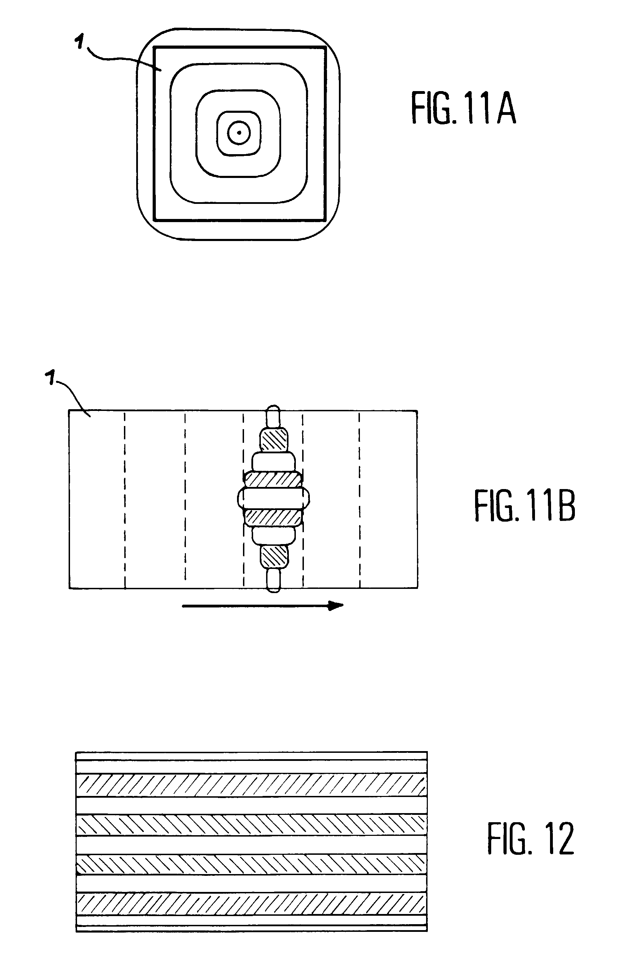

Les figures 11A et 11B proposent une répartition possible des parties testées d'une tranche de l'objet 1. Cette répartition correspond à des anneaux concentriques. Par déplacement de l'objet 1 dans la direction montrée par une flèche sur la figure 11B, les parties testées deviennent des tubes concentriques. La figure 12 représente la coupe de l'objet le long de l'axe du déplacement ainsi que la coupe des parties testées. Le signal total est obtenu par accumulation des signaux pondérés obtenus pour chaque tube, la pondération étant définie soit par une caractéristique de référence, soit par une modélisation de la réponse de chaque tube. Le signal pour chaque tube est lui aussi obtenu par accumulation des signaux obtenus dans l'anneau correspondant et définissant, lors du déplacement de l'objet, le tube considéré.

Le cas représenté aux figures 11A, 11B et 12 correspond à un système à une bobine pour le champ statique et une structure "Watson" pour le champ RF. Ces anneaux sont à épaisseurs radiale et transverse variables.

Les structures statique et RF sont optimisées afin que les formes des parties mesurées soient identiques pour le champ statique et pour le champ RF. Par exemple pour un même anneau, le champ statique sera homogène à ± 1% et le champ RF à ± 10%.

Si les mesures sont effectuées dans une ambiance industrielle, des moyens de découplage sont nécessaires. L'utilisation d'une cage de Faraday peut s'avérer délicate. Il est proposé, selon la présente invention d'utiliser des noyaux magnétiques. Cette solution présente l'avantage de focaliser l'induction RF dans le volume utile et donc de découpler la bobine d'induction RF par rapport aux sources de bruit externes à ce volume.

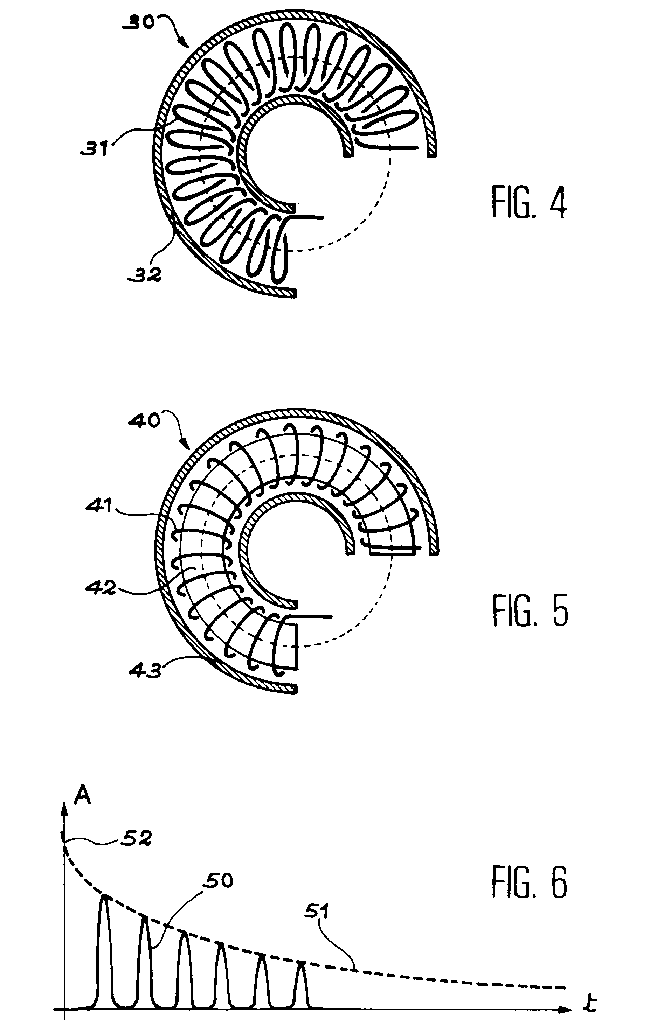

Ainsi, la figure 3 montre une bobine d'induction RF 20 comportant un enroulement 21 réalisé autour d'un noyau 22. Le noyau peut être réalisé à partir de ferrite, ce qui limite la fréquence à 200 kHz, soit une induction statique de l'ordre de 0,005 T. On peut également utiliser un autre matériau magnétique doux.

Une autre solution consiste à concentrer les lignes d'induction en utilisant un écran électromagnétique qui repousse les lignes d'induction RF. Cette solution permet aussi une focalisation du signal RF dans le volume utile et, par le phénomène d'écran, une limitation du couplage des bobines d'induction RF avec les sources externes. La figure 4 montre une bobine d'induction RF 30 comportant un enroulement 31 logé dans un écran électromagnétique 32 vu en coupe.

Cette solution implique le choix du matériau constituant l'écran. Ce choix est lié à la fréquence RF, les paramètres de choix étant la conductivité électrique et la perméabilité magnétique qui contrôlent l'effet de peau donc la charge sur la bobine d'induction RF. Le fer doux par exemple est un bon compromis à 1 MHz.

Une autre solution consiste à associer les deux solutions précédentes, ce qui permet en particulier une meilleure optimisation de l'écran. C'est ce que représente la figure 5 qui montre une bobine d'induction RF 40 comportant un enroulement 41 enroulé autour du noyau 42 et logé dans un écran électromagnétique 43 vu en coupe.

Les figures 4 et 5 illustrent l'utilisation d'un écran électromagnétique de forme tubulaire. Il est également possible d'utiliser un écran électromagnétique ouvert, par exemple un écran en forme de gouttière venant coiffer l'enroulement. Cette solution permet de limiter les courants de Foucault. Elle permet l'utilisation d'un écran bon conducteur électrique (par exemple en cuivre) et est utilisable avec tout type d'antenne.

Pour le dispositif selon l'invention, l'homogénéité de l'induction statique est de l'ordre de 1 % (cette homogénéité est de l'ordre de 0,001% pour les systèmes d'imagerie médicale). De fait, la largeur de bande du signal est aussi de quelques %. Ceci a pour conséquence que le système est moins critique et accepte donc les perturbations introduites par le cerclage sur le signal.

Pour pallier au défaut d'homogénéité, on peut utiliser des séquences de mesure CPMG (Carr-Purcell-Meiboom-Gill). Ces séquences permettent d'obtenir la décroissance du signal RMN en fonction du temps. De l'extrapolation de l'amplitude à l'origine des temps, on obtient une valeur proportionnelle à la quantité d'eau contenue dans la balle de papier.

Le facteur de proportionnalité est déduit d'expériences d'étalonnage, dans les mêmes conditions de programmation, des paramètres expérimentaux (courants continu et RF, vitesse de déplacement) et ceci à partir d'un objet significatif, par exemple une cuve de dimensions semblables à celles de l'objet à mesurer.

La figure 6 est un diagramme représentant un signal d'une séquence CPMG. L'axe des ordonnées représente l'amplitude A du signal et l'axe des abscisses le temps t. Le diagramme montre des impulsions 50 de détection de la séquence CPMG et, en pointillés, la décroissance multi-exponentielle 51 des impulsions détectées. La référence 52 indique l'extrapolation du signal à l'origine des temps.

De l'analyse de la décroissance à partir de modèles multi-exponentiels, il est possible d'en déduire un histogramme de la dimension caractéristique des pores présents dans l'objet.

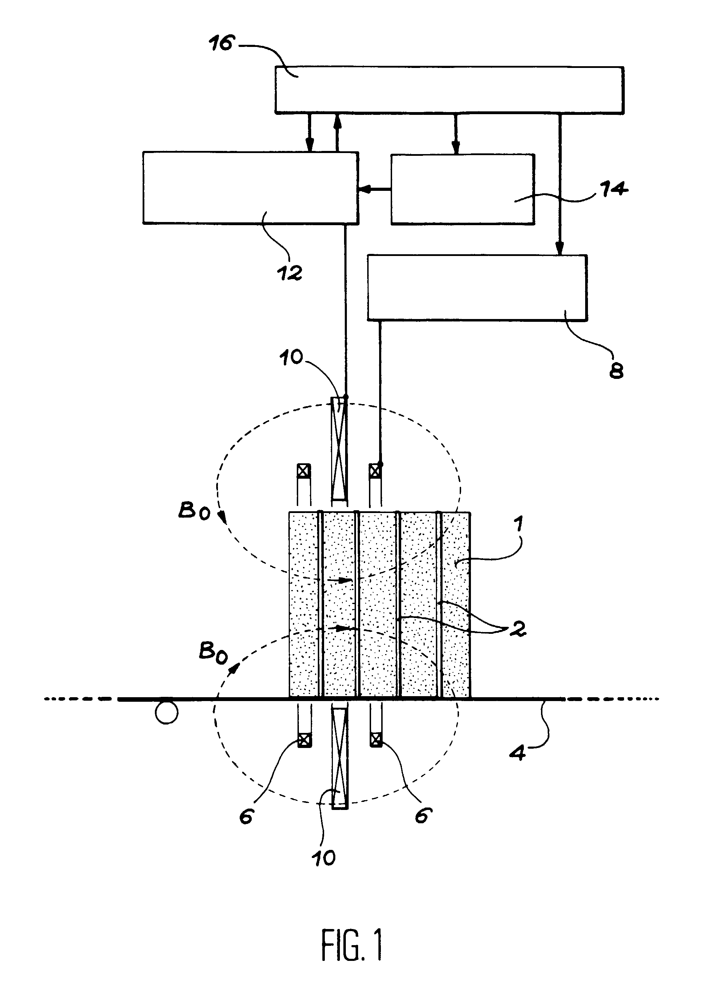

En revenant à la figure 1, la balle 1 est placée sur un tapis roulant 4 dont la vitesse de déplacement est programmée. Le système RF comprend des bobines d'induction 10 définies et réparties afin que la direction du champ magnétique qu'elle génère (voir le champ $B_1$ sur la figure 2) soit parallèle aux plans de cerclage. Les bobines d'induction 10 sont alimentées par des sources de courant programmées en amplitude et en phase dans le temps à la fréquence de résonance imposée par le champ magnétique statique.

Le système d'induction statique est constitué de deux bobines 6 coaxiales, d'axe parallèle à la direction de déplacement de la balle afin que $B_o$ soit perpendiculaire à $B_1$ dans la zone de mesure. Ces bobines 6 sont alimentées par des sources de courant programmées en amplitude en fonction du temps.

Le dispositif de la figure 1 comprend encore un séquenceur programmé 14 et un ordinateur 16 utilisé pour la programmation à l'émission et à l'acquisition.

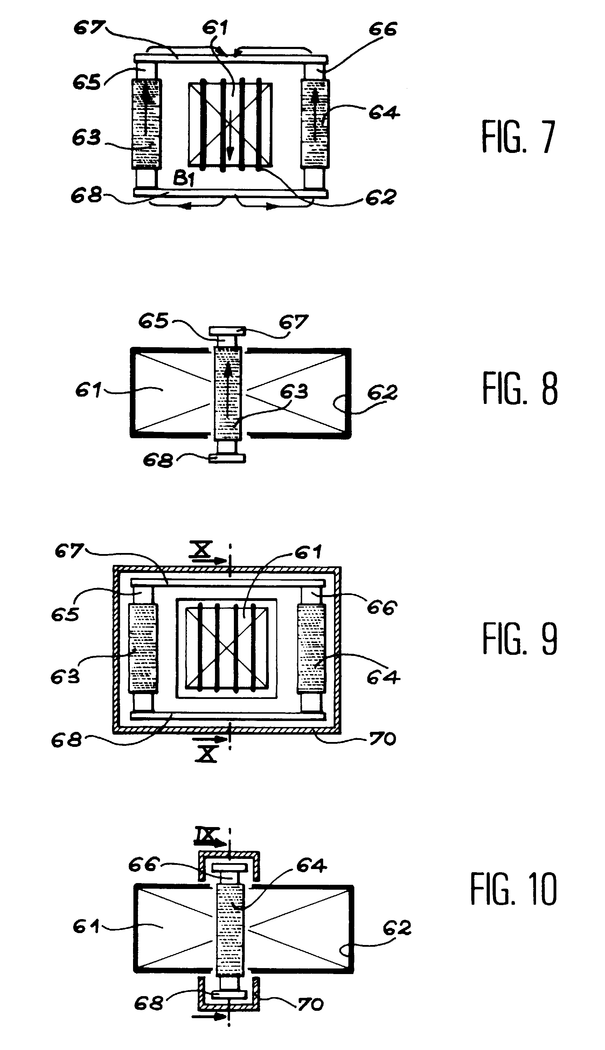

Les figures 7 et 8 illustrent une autre façon de fournir un champ électromagnétique RF. Comme on le remarque sur ces figures la balle 61, par exemple une balle de papier, est de forme parallélépipédique. Cette balle 61 est maintenue par des liens métalliques 62. Son déplacement s'effectue de la droite vers la gauche lorsque l'on considère la figure 8.

Afin de minimiser le couplage entre les bobines d'induction RF et les liens métalliques, l'induction RF représentée par le vecteur $\vec{B}_1$ doit être dans le plan des cerclages. L'induction statique peut être transverse ou longitudinale, la solution transverse étant la plus favorable puisque la section de balle est plus faible.

Afin que l'induction RF ne coupe pas la section des cerclages, on utilise une structure magnétique à noyau de type "Watson". Le champ magnétique RF est fourni par des enroulements 63 et 64 disposés respectivement autour de noyaux 65 et 66 en ferrite doux. Des pièces polaires 67 et 68, également en ferrite doux, relient les pôles de même signe des bobines RF ainsi constituées. Comme le montre la figure 7, l'induction RF traverse la balle 61 selon une direction verticale, sans couper la section des cerclages.

Il est intéressant d'optimiser la géométrie de la structure magnétique montrée sur les figures 7 et 8 afin de minimiser la masse de ferrite doux. Différentes solutions pour parvenir à ce résultat sont connues de l'homme de l'art : pièces polaires rapportées, en biseau, inclinées, inclinées et en biseau, courbées. Afin d'optimiser la répartition de l'induction dans la direction perpendiculaire au plan principal de la structure magnétique, la section des pièces polaires peut avoir des configurations variées : pièces polaires plates, en chapeau incliné, en chapeau incliné et plat, en chapeau courbe.

Cette structure magnétique de type "Watson" peut également être pourvue d'un écran électromagnétique ouvert comme cela est illustré par les figures 9 et 10 qui reprennent le dispositif de base représenté aux figures 7 et 8. La figure 9 est une vue selon la coupe IX-IX de la figure 10 qui est elle-même une vue selon la coupe X-X de la figure 9. Sur ces figures, on distingue bien l'écran électromagnétique 70 en forme de gouttière disposé autour de la structure magnétique RF.

## Revendications

1.　Méthode de caractérisation par RMN d'un objet (1) perméable poreux, consistant à :

- déplacer ledit objet (1) à une vitesse connue et dans une direction donnée pour que des anneaux concentriques de chacune des tranches successives de cet objet subissent une mesure RMN grâce à un champ magnétique statique $(B_o)$ et à un champ électromagnétique RF $(B_1)$ de direction perpendiculaire au champ magnétique statique et de fréquence égale à la fréquence de résonance définie par le champ électromagnétique statique,

- soumettre les anneaux concentriques de chacune des tranches à l'effet combiné dudit champ magnétique statique dont l'intensité est ajustée et dudit champ électromagnétique RF fourni sous forme d'impulsions dont l'amplitude et la durée sont ajustées,

- recueillir, pour les anneaux concentriques de chacune des tranches, des données de mesure RMN,

- pondérer les données recueillies en fonction du volume des anneaux concentriques soumis à la mesure RMN,

- délivrer les données pondérées à un ordinateur (16) qui les compare à des valeurs emmagasinées, obtenues par étalonnage ou modélisation sous des conditions de mesure identiques, pour fournir des données de caractérisation de l'objet (1) consistant en son taux d'humidité et/ou sa porosité et/ou la taille de ses pores.

**2.** Méthode selon la revendication 1, caractérisée en ce que l'intensité du champ magnétique statique est ajustée par variation du courant continu alimentant une bobine d'induction (6).

**3.** Méthode selon l'une des revendications 1 ou 2, caractérisée en ce que le champ magnétique statique est de direction parallèle au déplacement dudit objet (1), le champ électromagnétique RF étant de direction perpendiculaire au déplacement dudit objet (1) .

**4.** Méthode selon l'une quelconque des revendications 1 à 3, caractérisée en ce que la mesure RMN utilise des séquences CPMG.

**5.** Dispositif de caractérisation par RMN d'un objet (1) perméable poreux pour en déterminer le taux d'humidité et/ou la porosité et/ou la taille des pores, comportant :

- des moyens (4) de déplacement dudit objet (1) à une vitesse déterminée et dans une direction déterminée,
- des moyens (6, 8) de production d'un champ magnétique statique ($B_0$) d'intensité ajustable, aptes à générer ce champ magnétique statique de façon homogène dans des anneaux concentriques de chacune des tranches successives dudit objet,
- des moyens (10, 12) de production d'un champ électromagnétique RF ($B_1$), aptes à générer ce champ électromagnétique RF de façon homogène dans les anneaux concentriques de chacune des tranches dudit objet (1), dans une direction perpendiculaire au champ magnétique statique, à une fréquence égale à la fréquence de résonance définie par le champ magnétique statique et sous forme d'impulsions dont l'amplitude et la durée sont ajustables,
- des moyens de mesure RMN recueillant, pour lesdits anneaux concentriques de chacune des tranches, les données de mesure RMN,
- un ordinateur (16) auquel sont fournies les données de mesure RMN et qui les compare à des valeurs emmagasinées obtenues par étalonnage ou modélisation sous des conditions de mesure identiques pour délivrer des données de caractérisation de l'objet (1) .

**6.** Dispositif selon la revendication 5, caractérisé en ce que les moyens de déplacement dudit objet sont constitués par un tapis roulant (4).

**7.** Dispositif selon l'une des revendications 5 ou 6, caractérisé en ce que les moyens (4) de déplacement dudit objet, les moyens (6, 8) de production d'un champ magnétique statique et les moyens (10, 12) de production d'un champ électromagnétique RF sont disposés de façon que le champ magnétique statique soit parallèle au déplacement de l'objet (1) et de façon que le champ électromagnétique RF soit perpendiculaire au déplacement de l'objet.

**8.** Dispositif selon l'une quelconque des revendications 5 à 7, caractérisé en ce que les moyens de production d'un champ magnétique statique comprennent des moyens à bobine d'induction (6) pour ajuster l'intensité du champ magnétique statique grâce à une variation de courant continu.

**9.** Dispositif selon la revendication 8, caractérisé en ce que les moyens de production d'un champ magnétique statique comprennent en outre des moyens à aimant permanent.

**10.** Dispositif selon l'une quelconque des revendications 5 à 9, caractérisé en ce que les moyens de production d'un champ électromagnétique RF sont des moyens à bobine d'induction (10) alimentée par une source RF (12).

**11.** Dispositif selon la revendication 10, caractérisé en ce que ladite bobine d'induction (20, 40) des moyens de production d'un champ électromagnétique RF comporte un noyau en matériau magnétique (22, 42).

**12.** Dispositif selon la revendication 11, caractérisé en ce que ledit matériau magnétique est du ferrite doux.

**13.** Dispositif selon la revendication 10, caractérisé en ce que ladite bobine d'induction (30, 40) des moyens de production d'un champ électromagnétique RF est pourvue d'un écran électromagnétique (32, 43) de protection réalisé en un matériau présentant une conductivité électrique et une perméabilité magnétique non nulles.

**14.** Dispositif selon la revendication 13, caractérisé en ce que ledit écran électromagnétique (32, 43) est en fer doux.

**15.** Dispositif selon la revendication 14, caractérisé en ce que ladite bobine d'induction (40) des moyens de production d'un champ électromagnétique RF comporte également un noyau en ferrite (42).

**16.** Dispositif selon la revendication 10, caractérisé en ce qu'un circuit magnétique (65 à 68) est associé aux moyens à bobine d'induction (63, 64) pour la production d'un champ électromagnétique RF, le circuit magnétique permettant de favoriser la circulation du flux électromagnétique RF.

**17.** Dispositif selon la revendication 16, caractérisé en ce que ledit circuit magnétique (65 à 68) est un circuit de type "Watson".

**18.** Dispositif selon l'une des revendications 16 ou 17, caractérisé en ce que ledit circuit magnétique (65 à 68) est pourvu d'un écran électromagnétique (70) de protection réalisé en un matériau présentant une conductivité électrique et une perméabilité magnétique non nulles.

**19.** Dispositif selon l'une quelconque des revendications 5 à 18, caractérisé en ce que lesdits moyens de mesure RMN sont des moyens aptes à mettre en oeuvre des séquences CPMG.

**20.** Utilisation du dispositif selon l'une quelconque des revendications 5 à 19 à la caractérisation de balles de papier (1) cerclées par des liens métalliques parallèles (2) définissant des plans de cerclage, la mesure RMN s'effectuant avec un champ électromagnétique RF tel que la somme des flux entrant et sortant d'un plan de cerclage soit nulle et avec un champ magnétique statique de direction perpendiculaire à celle du champ RF.

**21.** Utilisation selon la revendication 20, caractérisée en ce que le champ électromagnétique RF est dans le plan de cerclage.

FIG.1

FIG. 2

FIG. 3

FIG. 4

FIG. 5

FIG. 6

FIG. 7

FIG. 8

FIG. 9

FIG. 10

FIG.11A

FIG.11B

FIG. 12

Office européen
des brevets

**RAPPORT DE RECHERCHE EUROPEENNE**

Numéro de la demande

EP 99 40 2964

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 0 367 494 A (AMOCO CORP) 9 mai 1990 (1990-05-09) * colonne 7, ligne 30 - colonne 8, ligne 54 * * colonne 10, ligne 7 - colonne 12, ligne 11; figure 1 * | 1,2,5,8, 10 | G01R33/44 |
| A | US 4 701 705 A (ROLLWITZ WILLIAM L) 20 octobre 1987 (1987-10-20) * colonne 1, ligne 5 - colonne 3, ligne 47 * * colonne 4, ligne 8 - colonne 6, ligne 23; figures 1-3 * | 1,5,6,10 | |
| A | US 4 728 892 A (VINEGAR HAROLD J ET AL) 1 mars 1988 (1988-03-01) * colonne 3, ligne 1 - colonne 4, ligne 68; figures 1-3 * | 1,2,4,5, 8,10,19 | |
| A | US 5 049 819 A (DECHENE RONALD L ET AL) 17 septembre 1991 (1991-09-17) * colonne 5, ligne 6 - colonne 8, ligne 8; figures 1,2 * | 1,2,5, 8-10,13 | DOMAINES TECHNIQUES RECHERCHES (Int.Cl.7) G01R |
| A | US 2 999 977 A (INDUSTRIAL NUCLEONICS CORPORATION) 12 septembre 1961 (1961-09-12) * colonne 3, ligne 48 - colonne 5, ligne 57; figures 1-4 * | 1,5 | |
| A | A.De Los Santos: "Practical Considerations for NMR/MRI in NDT", IEE Colloquium on NMR/MRI used in NDT, London, UK, Feb 9 1994, Nr. 033, pg. 2/1 XP002112575 | 1,5 | |

Le présent rapport a été établi pour toutes les revendications

| Lieu de la recherche | Date d'achèvement de la recherche | Examinateur |
|---|---|---|
| MUNICH | 9 mars 2000 | Lersch, W |

**ANNEXE AU RAPPORT DE RECHERCHE EUROPEENNE
RELATIF A LA DEMANDE DE BREVET EUROPEEN NO.**

EP 99 40 2964

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-03-2000

| Document brevet cité au rapport de recherche | | Date de publication | Membre(s) de la famille de brevet(s) | | | Date de publication |
|---|---|---|---|---|---|---|
| EP 0367494 | A | 09-05-1990 | US | 4885540 | A | 05-12-1989 |
| | | | CA | 1307319 | A | 08-09-1992 |
| | | | DE | 68912271 | D | 24-02-1994 |
| | | | DE | 68912271 | T | 28-04-1994 |
| | | | EG | 18816 | A | 30-03-1994 |
| US 4701705 | A | 20-10-1987 | AUCUN | | | |
| US 4728892 | A | 01-03-1988 | AUCUN | | | |
| US 5049819 | A | 17-09-1991 | CA | 2106404 | A,C | 20-09-1992 |
| | | | WO | 9216851 | A | 01-10-1992 |
| | | | US | 5015954 | A | 14-05-1991 |
| | | | EP | 0576421 | A | 05-01-1994 |
| | | | ES | 2125867 | T | 16-03-1999 |
| | | | JP | 6509161 | T | 13-10-1991 |
| | | | AU | 653516 | B | 06-10-1992 |
| | | | DE | 69130574 | D | 14-01-1999 |
| | | | DE | 69130574 | T | 29-04-1999 |
| US 2999977 | A | 12-09-1961 | AUCUN | | | |

EPO FORM P0460

Pour tout renseignement concernant cette annexe : voir Journal Officiel de l'Office européen des brevets, No.12/82